# EUROPÄISCHE PATENTANMELDUNG

(11) **EP 0 534 269 A2**
(43) Veröffentlichungstag der Anmeldung: **31.03.1993**
(21) Anmeldenummer: 92115702.0
(22) Anmeldetag: 14.09.1992
(51) Int. Cl.: C25D 5/08, C25D 17/00, H05K 3/42

(54) **Galvanisiereinrichtung für im horizontalen Durchlauf zu behandelnde gelochte Leiterplatten**

(30) Priorität: 26.09.1991 DE 4132145
(71) Anmelder: SIEMENS AKTIENGESELLSCHAFT, D-80333 München (DE)
(72) Erfinder: Hosten, Daniel, B-8610 Handzame (BE); van Puymbroeck, Josef, B-8020 Oostkamp (BE)

(57) **Zusammenfassung**

Die Galvanisiereinrichtung umfaßt mehrere quer zur Durchlaufbahn der Leiterplatten (Lp) ausgerichtete und oberhalb der Durchlaufbahn abwechselnd angeordnete obere Elektrolyt-Zuführeinrichtungen (EZo) und obere Elektrolyt-Ablaufeinrichtungen (EAo), sowie mehrere quer zur Durchlaufbahn ausgerichtete und unterhalb der Durchlaufbahn abwechselnd angeordnete untere Elektrolyt-Zuführeinrichtungen (EZu) und untere Elektrolyt-Ablaufeinrichtungen (EAu), wobei jeweils einer oberen Elektrolyt-Zuführeinrichtung (EZo) eine untere Elektrolyt-Ablaufeinrichtung (EAu) und einer unteren Elektrolyt-Zuführeinrichtung (EZu) eine obere Elektrolyt-Ablaufeinrichtung (EAo) gegenüberliegt. Hierdurch ergeben sich vertikale und horizontale Strömungskomponenten der Elektrolytlösung, deren Richtung in Durchlaufrichtung (Dr) der Leiterplatten (Lp) gesehen ständig wechselt.

## Beschreibung

Aus der DE-A-32 36 545 ist eine Galvanisiereinrichtung für Leiterplatten bekannt, bei welcher die Leiterplatten im horizontalen Durchlauf durch ein Elektrolytbad geführt werden. Der Vorschub der Leiterplatten erfolgt über angetriebene Kontaktierräder, die auf einer Seite im Bad angeordnet sind und gleichzeitig auch die kathodische Kontaktierung der Werkstücke übernehmen. Auf der den Kontaktierrädern gegenüberliegenden Seite ist zur Führung und Halterung der Werkstücke eine besondere Gleitbefestigung im Bad angeordnet. Bei den im Elektrolytbad angeordneten Anoden handelt es sich um lösliche Anodenstäbe, die quer zur Durchlaufbahn ausgerichtet und sowohl oberhalb als auch unterhalb der Durchlaufbahn angeordnet sind. Gemäß einer Variante können die oberen und unteren Anoden aber auch durch Titankörbe gebildet werden, die das lösliche Anodenmaterial in Form von Kugeln enthalten. In der Auffangwanne der Galvanisiereinrichtung sind oberhalb und unterhalb der Durchlaufbahn in Durchlaufrichtung ausgerichtete Düsenstöcke angeordnet, welchen die Elektrolytlösung aus einem Vorratsbehälter mittels einer Vielzahl von Tauchpumpen zugeführt wird. Die hohe Fließgeschwindigkeit der Elektrolytlösung durch die Düsenstocke schafft neben dem Nachfüllen der Badzone auf das gewünschte Niveau auch eine gute Durchmischung der Elektrolytlösung, durch welche eine gleichförmige Zusammensetzung und gleicbmäßige Stromdichten gewährleistet werden sollen. Zur Schaffung noch größerer Turbulenzen im Bad können die Düsenstöcke auch horizontal oder in Durchlaufrichtung hin- und herbewegt werden.

Aus der EP-A-0 254 962 ist eine weitere Galvanisiereinrichtung für im horizontalen Durchlauf zu behandelnde Leiterplatten bekannt, bei welcher als Transport- und Kontaktierorgan zangenförmige Kontaktklemmen vorgesehen sind, welche auf einem endlos umlaufenden Trieb angeordnet sind und die Seitenränder der Leiterplatten fassen.

Bei einer aus der EP-B-0 276 725 bekannten Galvanisiereinrichtung für im horizontalen Durchlauf zu behandelnde gelochte Leiterplatten sind einlaufseitig und auslaufseitig jeweils oberhalb und unterhalb der Durchlaufbahn quer dazu ausgerichtete Elektrolytsammler mit zwischen Durchlaufbahn und obere bzw. untere Anode gerichteten Öffnungen für den Zulauf und/oder Ablauf von Elektrolytlösung angeordnet. Durch die Anordnung der Elektrolytsammler werden Strömungskomponenten der Elektrolytflüssigkeit in Längsrichtung erzeugt. Zusätzlich werden aber auch noch durch quer zur Durchlaufrichtung ausgerichtete untere Schwalldüsen vertikale Strömungskomponenten der Elektrolytlösung erzeugt, die insbesondere für die Herstellung von Durchkontaktierungen in den gelochten Leiterplatten von Bedeutung sind.

Der im Anspruch 1 angegebenen Erfindung liegt das Problem zugrunde, beim Durchkontaktieren und Galvanisieren von gelochten Leiterplatten die Qualität und die Schichtdickenverteilung der abgeschiedenen Metallschichten weiter zu verbessern.

Die mit der Erfindung erzielten Vorteile bestehen insbesondere darin, daß vertikale Strömungskomponenten für eine gute Durchströmung von Durchkontaktierungslöchern sorgen, wobei die Richtung dieser vertikalen Strömungskomponenten in Durchlaufrichtung gesehen ständig wechselt. In entsprechender Weise ergibt sich auch bei den oberhalb und unterhalb der Durchlaufbahn ausgebildeten horizontalen Strömungskomponenten in Durchlaufrichtung gesehen ein ständiger Richtungswechsel. Durch diesen ständigen Richtungswechsel der im übrigen von der Länge der Galvanisiereinrichtung vollständig unabhängigen horizontalen und vertikalen Strömungskomponenten können auch bei hohen Stromdichten hochwertige Metallschichten mit einer guten Duktilität, einer hohen Haftfestigkeit und einer überaus gleichmäßigen Schichtdickenverteilung abgeschieden werden.

Vorteilhafte Ausgestaltungen der Erfindung sind in den Ansprüchen 2 bis 4 angegeben.

Die Ausgestaltung nach Anspruch 2 ermöglicht mit geringem Aufwand die Ausbildung von stark ausgeprägten vertikalen Strömungskomponenten.

Die Weiterbildung nach Anspruch 3 ermöglicht eine Integration der oberen Elektrolyt-Zuführeinrichtungen bzw. Elektrolyt-Ablaufeinrichtungen in die obere Anode, bei guter Zugänglichkeit des Anodenmaterials. Dieser Vorteil wird dann gemäß Anspruch 4 auch für die unteren Elektrolyt-Zuführeinrichtungen bzw. Elektrolyt-Ablaufeinrichtungen in Verbindung mit der unteren Anode realisiert.

Ein Ausführungsbeispiel der Erfindung ist in der Zeichnung dargestellt und wird im folgenden näher beschrieben.

Es zeigen:
Figur 1 die erfindungsgemäße Anordnung von Elektrolyt-Zuführeinrichtungen und Elektrolyt-Ablaufeinrichtungen und
Figur 2 die Ausbildung von horizontalen und vertikalen Strömungskomponenten bei der Anordnung nach Figur 1.

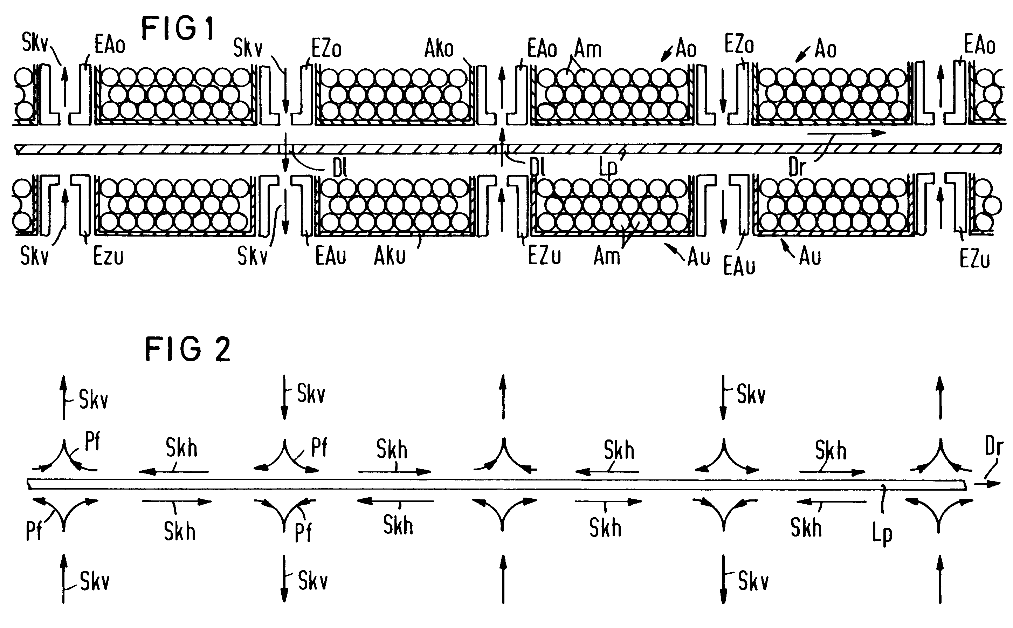

Gemäß Figur 1 werden die zu galvanisierenden Leiterplatten Lp in horizontaler Lage und in horizontaler Durchlaufrichtung Dr zwischen einer oberen Anode Ao und einer unteren Anode Au durch eine nicht näher dargestellte Elektrolytlösung transportiert. Die obere Anode Ao besteht aus einzelnen oberen Anodenkörben Ako, in welchen sich kugelförmiges Anodenmaterial Am befindet. In ähnlicher Weise besteht die untere Anode Au aus einzelnen unteren Anodenkörben Aku, in welchen sich ebenfalls kugelförmiges Anodenmaterial Am befindet. Die Anodenkörbe Ako und Aku bestehen beispielsweise aus Titan, während es sich bei dem Anodenmaterial Am in dem beschriebenen Ausführungsbeispiel um Kupferkugeln handelt.

Oberhalb der Durchlaufbahn der Leiterplatten Lp sind jeweils zwischen zwei oberen Anodenkörben Ako in Durchlaufrichtung Dr gesehen abwechselnd obere Elektrolyt-Zuführeinrichtungen EZo und obere Elektrolyt-Ablaufeinrichtungen EAo angeordnet. In entsprechender Weise sind unterhalb der Durchlaufbahn der Leiterplatten Lp jeweils zwischen zwei unteren Anodenkörben Aku in Durchlaufrichtung Dr gesehen abwechselnd untere Elektrolyt-Zuführeinrichtungen EZu und untere Elektrolyt-Ablaufeinrichtungen EAu angeordnet. Dabei liegt stets einer oberen Elektrolyt-Zuführeinrichtung EZo eine untere Elektrolyt-Ablaufeinrichtung EAo gegenüber, während den unteren Elektrolyt-Zuführeinrichtungen EZu stets eine obere Elektrolyt-Ablaufeinrichtung EAo gegenüberliegt.

Die als Schwalldüsen ausgebildeten und quer zur Durchlaufbahn ausgerichteten oberen und unteren Elektrolyt-Zufuhreinrichtungen EZo und EZu erzeugen vertikal auf die Oberfläche der Leiterplatten Lp gerichtete Strömungskomponenten Skv der Elektrolytlösung. Die ähnlich wie Schwalldüsen, jedoch mit größerem Querschnitt der Schlitze, ausgebildeten und ebenfalls quer zur Durchlaufbahn ausgerichteten oberen und unteren Elektrolyt-Ablaufeinrichtungen EAo und EAu führen die Elektktrolytlösung mit vertikalen, von der Oberfläche der Leiterplatten Lp wegführenden Strömungskomponenten Skv ab. Dementsprechend werden Durchkontaktierungslöcher Dl der Leiterplatten Lp zwischen einer oberen Elektrolyt-Zuführeinrichtung EZo und einer unteren Elektrolyt-Ablaufeinrichtung EAu senkrecht von oben nach unten und zwischen einer unteren Elektrolyt-Zuführeinrichtung EZu und einer oberen Elektrolyt-Ablaufeinrichtung EAo senkrecht von unten nach oben durchströmt, so wie es in Figur 1 an zwei Stellen aufgezeigt ist.

Im übrigen ergibt sich beim Durchlauf der Leiterplatten Lp durch die Galvanisiereinrichtung die in Figur 2 dargestellte Verteilung von vertikalen Strömungskomponenten Skv und horizontalen Strömungskomponenten Skh der Elektrolytlösung. Es ist zu erkennen, daß die vertikal auf die Oberfläche der Leiterplatten Lp gerichteten Strömungskomponenten Skv in Richtung der Pfeile Pf umgelenkt werden und somit zur Ausbildung der horizontalen Strömungskomponenten Skh führen. Diese horizontalen Strömungskomponenten Skh werden dann ihrerseits im Bereich der oberen und unteren Elektrolyt-Ablaufeinrichtungen in Richtung der Pfeile Pf umgelenkt, wobei von der Oberfläche der Leiterplatten Lp wegführende vertikale Strömungskomponenten Skv entstehen.

Figur 2 zeigt auch deutlich, daß durch die spezielle Anordnung von oberen und unteren Elektrolyt-Zuführeinrichtungen EZo und EZu und von oberen und unteren Elektrolyt-Ablaufeinrichtungen EAo und EAu (vgl. Fig. 1) sich in Durchlaufrichtung Dr der Leiterplatten Lp gesehen ein ständiger Richtungswechsel der vertikalen Strömungskomponenten Skv und der horizontalen Strömungskomponenten Skh ergibt.

Die in der Zeichnung nicht dargestellte Zufuhr der Elektrolytlösung zu den oberen Elektrolyt-Zuführeinrichtungen EZo erfolgt beispielsweise über eine gemeinsame Pumpe. In entsprechender Weise ist dann auch den unteren Elektrolyt-Zuführeinrichtungen EZu eine gemeinsame Pumpe zugeordnet. Diese beiden Pumpen saugen die Elektrolytlösung aus einem Vorratsbehälter an, in welchen die ebenfalls nicht dargestellten Ablaufleitungen der oberen und unteren Elektrolyt-Ablaufeinrichtungen EAo und EAu einmünden.

Der aus Figur 2 ersichtliche ständige Richtungswechsel der vertikalen Strömungskomponenten Skv und der horizontalen Strömungskomponenten Skh führt zu optimalen Schichtdickenverteilungen der galvanisch abgeschiedenen Schichten, sowohl auf den Oberflächen der Leiterplatten Lp als auch in den Durchkontaktierungslöchern Dl (vgl. Fig. 1). Der Transport und die kathodische Kontaktierung der Leiterplatten Lp sind in der Zeichnung nicht dargestellt. Hierzu können Kontaktierräder, Kontaktierwalzen oder auch mit den Leiterplatten mitlaufende zangenförmige Kontaktklemmen verwendet werden.

## Patentansprüche

1. Galvanisiereinrichtung für im horizontalen Durchlauf zu behandelnde gelochte Leiterplatten (Lp), mit
- mindestens einer oberhalb der Durchlaufbahn angeordneten oberen Anode (Ao),
- mindestens einer unterhalb der Durchlaufbahn angeordneten unteren Anode (Au),
- mehreren quer zur Durchlaufbahn ausgerichteten und oberhalb der Durchlaufbahn abwechselnd angeordneten oberen Elektrolyt-Zuführeinrichtungen (EZo) und oberen Elektrolyt-Ablaufeinrichtungen (EAo) und mit
- mehreren quer zur Durchlaufbahn ausgerichteten und unterhalb der Durchlaufbahn abwechselnd angeordneten unteren Elektrolyt-Zuführeinrichtungen (EZu) und unteren Elektrolyt-Ablaufeinrichtungen (EAu), wobei
- jeweils einer oberen Elektrolyt-Zuführeinrichtung (EZo) eine untere Elektrolyt-Ablaufeinrichtung (EAu) und einer unteren Elektrolyt-Zuführeinrichtung (EZu) eine obere Elektrolyt-Ablaufeinrichtung (EAo) gegenüberliegt.

2. Galvanisiereinrichtung nach Anspruch 1,
**dadurch gekennzeichnet,**
daß die oberen und unteren Elektrolyt-Zuführeinrichtungen (EZo, EZu) als Schwalldüsen mit senkrecht auf die Oberfläche der Leiterplatten (Lp) gerichteten Strömungskomponenten (SKv) ausgebildet sind.

3. Galvanisiereinrichtung nach Anspruch 1 oder 2,
**dadurch gekennzeichnet,**
daß die oberen Elektrolyt-Zuführeinrichtungen (EZo) und die oberen Elektrolyt-Ablaufeinrichtungen (EAo) jeweils zwischen zwei oberen Anodenkörben (Ako) angeordnet sind.

4. Galvanisiereinrichtung nach einem der Ansprüche 1 bis 3,
**dadurch gekennzeichnet,**
daß die unteren Elektrolyt-Zuführeinrichtungen (EZu) und die unteren Elektrolyt-Ablaufeinrichtungen (EAu) jeweils zwischen zwei unteren Anodenkörben (AKu) angeordnet sind.
